# EUROPEAN PATENT APPLICATION

(11) **EP 4 726 984 A1**
(43) Date of publication of application: **15.04.2026**
(21) Application number: 24830432.1
(22) Date of filing: 05.06.2024
(51) Int. Cl.: H02M 1/00, H02M 7/42, H01H 19/10, H01H 19/14

(54) **INVERTER**

(30) Priority: 30.06.2023 CN 202321713204 U
(71) Applicant: Huawei Digital Power Technologies Co., Ltd., Shenzhen, Guangdong 518043 (CN)
(72) Inventor: CHEN, Chao, Shenzhen, Guangdong 518043 (CN); WANG, Shiguang, Shenzhen, Guangdong 518043 (CN); GAO, Feng, Shenzhen, Guangdong 518043 (CN); YU, Huiyong, Shenzhen, Guangdong 518043 (CN)
(74) Representative: Maiwald GmbH
(86) International application number: PCT/CN2024/097444
(87) International publication number: WO 2025/001785

(57) **Abstract**

Embodiments of this application provide an inverter, and relate to the field of device technologies. The inverter includes a housing, a circuit board, a rotary switch, and a knob component, the rotary switch is fastened to the circuit board, the rotary switch includes a plurality of switches and an operating shaft, and the operating shaft is configured to drive the plurality of switches to be turned on or turned off. The housing is configured to accommodate the circuit board and the rotary switch, the housing includes two side plates, the two side plates are oppositely arranged along a first direction, one side plate in the two side plates includes a knob mounting hole, and the knob mounting hole penetrates the side plate along the first direction. The knob component includes a knob and a knob shaft, the knob shaft is configured to pass through the knob mounting hole and be in transmission connection to the operating shaft, the knob is configured to drive, through the knob shaft, the operating shaft to rotate, and the knob and the operating shaft are arranged on two sides of the side plate along the first direction. The inverter can resolve a problem of a large volume of the inverter.

## Description

### CROSS-REFERENCE TO RELATED APPLICATIONS

This application claims priority to Chinese Patent Application No. 202321713204.0, filed with the China National Intellectual Property Administration on June 30, 2023 and entitled "INVERTER", which is incorporated herein by reference in its entirety.

### TECHNICAL FIELD

This application relates to the field of device technologies, and in particular, to an inverter.

### BACKGROUND

A rotary switch is one of main components of an inverter, and is mainly used for conduction and interruption of a current. When the inverter is specifically disposed, the rotary switch is fastened to a circuit board in a housing of the inverter and is fastened to the housing of the inverter, and an operating shaft of the rotary switch passes through a through hole on the housing of the inverter and is connected to a knob located on an outer side of the housing. A disadvantage of the inverter is as follows: To install the circuit board and the rotary switch, the housing is large, and therefore a volume of the inverter is large.

### SUMMARY

An inverter provided in embodiments of this application can resolve a problem of a large volume of the inverter.

The inverter provided in embodiments of this application includes a housing, a circuit board, a rotary switch, and a knob component, the rotary switch is fastened to the circuit board, the rotary switch includes a plurality of switches and an operating shaft, and the operating shaft is configured to drive the plurality of switches to be turned on or turned off.

The housing is configured to accommodate the circuit board and the rotary switch, the housing includes two side plates, the two side plates are oppositely arranged along a first direction, one side plate in the two side plates includes a knob mounting hole, and the knob mounting hole penetrates the side plate along the first direction.

The knob component includes a knob and a knob shaft, the knob shaft is configured to pass through the knob mounting hole and be in transmission connection to the operating shaft, the knob is configured to drive, through the knob shaft, the operating shaft to rotate, and the knob and the operating shaft are arranged on two sides of the side plate along the first direction.

In this solution, the knob shaft in the knob component extends into the housing and is in transmission connection to the operating shaft of the rotary switch. When the inverter is assembled, the circuit board and the rotary switch fastened to the circuit board are placed in the housing, and the operating shaft of the rotary switch is enabled to be coaxial with the knob mounting hole on the side plate of the housing. Then, the knob shaft is enabled to extend into the housing and be in transmission connection to the operating shaft of the rotary switch. In a process of assembling the inverter, the circuit board and the rotary switch fastened to the circuit board do not need to be translated towards the knob mounting hole on the side plate. Therefore, in an axis direction of the knob mounting hole, the housing does not need to have extra installation space other than space for accommodating the circuit board and the rotary switch. This can improve space utilization of the housing, and help miniaturize the inverter and reduce manufacturing costs.

In addition, compared with a case in which the operating shaft of the rotary switch passes through an operating shaft mounting hole on the housing and is connected to the knob, in this solution, for the housing of a same size, the circuit board of a larger size may be disposed; and the rotary switch is fastened in the housing through the circuit board, and does not need to be separately connected to the housing, so that a problem of redundant fastening of the rotary switch is avoided.

In an embodiment, the circuit board includes two end faces, the two end faces are oppositely arranged along the first direction, and one end face in the two end faces is closer to the side plate than the other end face. A distance between an end face of the operating shaft and the knob mounting hole is greater than or equal to a distance between the end face and the knob mounting hole. In other words, a projection of the operating shaft along a direction perpendicular to the circuit board is at least partially located within a range of the circuit board. Compared with a case in which the operating shaft completely exceeds the circuit board along the first direction, this solution helps reduce a size of the housing in the first direction.

In an embodiment, the housing includes a bottom plate, the two side plates are both fastened to the bottom plate, the circuit board and the bottom plate are oppositely arranged along a second direction, and the second direction is perpendicular to the bottom plate. Therefore, a size of the inverter in the second direction can be reduced, and this is more conducive to application in a scenario in which the size of the inverter in the second direction is limited.

In an embodiment, the two side plates are both flat plates, and the circuit board is perpendicular to the two side plates. This simplifies processing steps of the two side plates, and simplifies an assembly process of the inverter.

In an embodiment, the rotary switch is located between the bottom plate and the circuit board along the second direction.

In an embodiment, the knob is in sealing cooperation with the side plate, and a projection of the knob along the first direction is located in the side plate. Therefore, a possibility that the knob rotates due to misoperation can be reduced; and compared with a case in which the projection of the knob along the first direction exceeds a range of the side plate, a possibility of interference between the knob and a surrounding apparatus or component can be reduced.

In an embodiment, both an axis direction of the operating shaft and an axis direction of the knob shaft overlap the first direction.

In an embodiment, both an axis direction of the operating shaft and an axis direction of the knob shaft are parallel to the circuit board.

In an embodiment, the plurality of switches are sequentially arranged along an axis direction of the operating shaft.

In an embodiment, the side plate includes a housing locking part, the knob includes a knob locking part, and the housing locking part can cooperate with the knob locking part to limit an orientation of the knob relative to the side plate. Therefore, a case in which the knob drives the knob shaft due to misoperation and therefore change an on/off state of the rotary switch is avoided.

### BRIEF DESCRIPTION OF DRAWINGS

FIG. 1 is a diagram of a structure of an inverter according to an embodiment of this application;
FIG. 2 is a diagram of assembly steps of the inverter shown in FIG. 1;
FIG. 3 is a diagram of other assembly steps of the inverter shown in FIG. 1;
FIG. 4 is an axonometric diagram of a knob component in an inverter according to an embodiment of this application;
FIG. 5 is an E-E sectional view of the knob component shown in FIG. 4;
FIG. 6 is a front view of the knob component shown in FIG. 4;
FIG. 7 is a top view of the knob component shown in FIG. 4; and
FIG. 8 is a bottom view of the knob component shown in FIG. 4.

### DESCRIPTION OF EMBODIMENTS

In a related technology, due to structural features of a rotary switch and a knob, when an inverter is assembled, a circuit board fastened with the rotary switch needs to be placed in a housing of the inverter from top to bottom first, and an operating shaft of the rotary switch is enabled to be coaxial with an operating shaft mounting hole on the housing of the inverter. Then, the circuit board and the rotary switch fastened to the circuit board are translated in a direction towards the operating shaft mounting hole until the operating shaft of the rotary switch passes through the operating shaft mounting hole on the housing and extends to the outside of the housing. Finally, the knob is fastened to the operating shaft and another subsequent assembly work is carried out. In other words, in an axis direction of the operating shaft mounting hole, redundant installation space needs to be reserved in the housing of the inverter. Consequently, space utilization in the housing of the inverter is low, and this is not conducive to miniaturizing the inverter and reducing manufacturing costs.

Based on this, embodiments of this application provide an inverter, to resolve the foregoing problem. To make objectives, technical solutions, and advantages of this application clearer, the following further describes this application in detail with reference to accompanying drawings.

It should be noted that the inverter in this application is an inverter with a rotary switch, for example, a photovoltaic inverter with a rotary switch.

Terms used in the following embodiments are merely intended to describe specific embodiments, but are not intended to limit this application. "One", "a", "the" and "this" of singular expression forms used in the specification and the appended claims of this application are also intended to include expression forms such as "one or more", unless otherwise specified in the context clearly.

Reference to "an embodiment", "some embodiments", or the like described in this specification means that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "include", "contain", "have", and other variants thereof all mean "include but are not limited to", unless otherwise specifically emphasized in another manner.

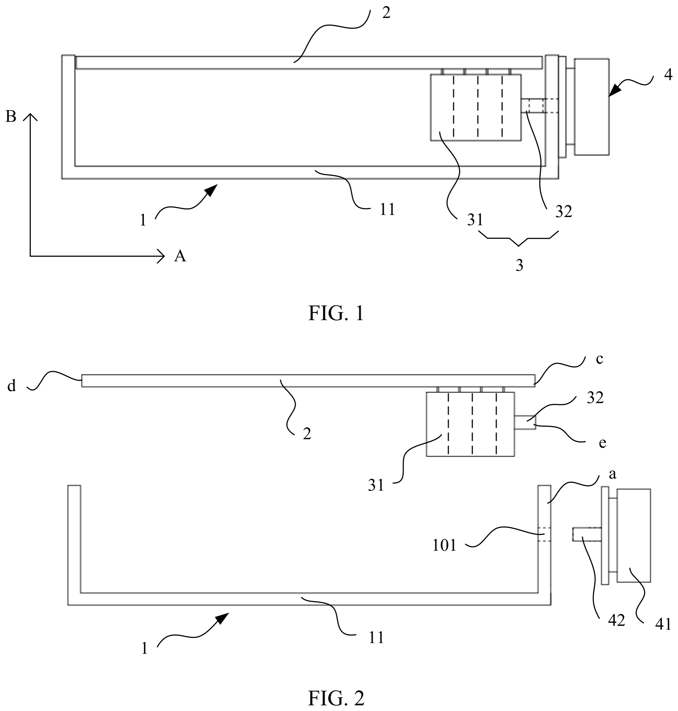

FIG. 1 is a diagram of a structure of an inverter according to an embodiment of this application. As shown in FIG. 1, the inverter includes a housing 1, a circuit board 2, a rotary switch 3, and a knob component 4. The circuit board 2 is fastened in the housing 1, and the rotary switch 3 is fastened to the circuit board 2. Specifically, the rotary switch 3 includes an operating shaft 32 and a plurality of switches 31. The plurality of switches 31 are sequentially connected to the operating shaft 32 along an axis direction of the operating shaft 32. The operating shaft 32 is configured to drive the plurality of switches 31 to be turned on or turned off, to implement conduction and interruption of a current. Clearly, a specific quantity of switches 31 in the rotary switch 3 is set according to an actual requirement. Therefore, details are not described herein.

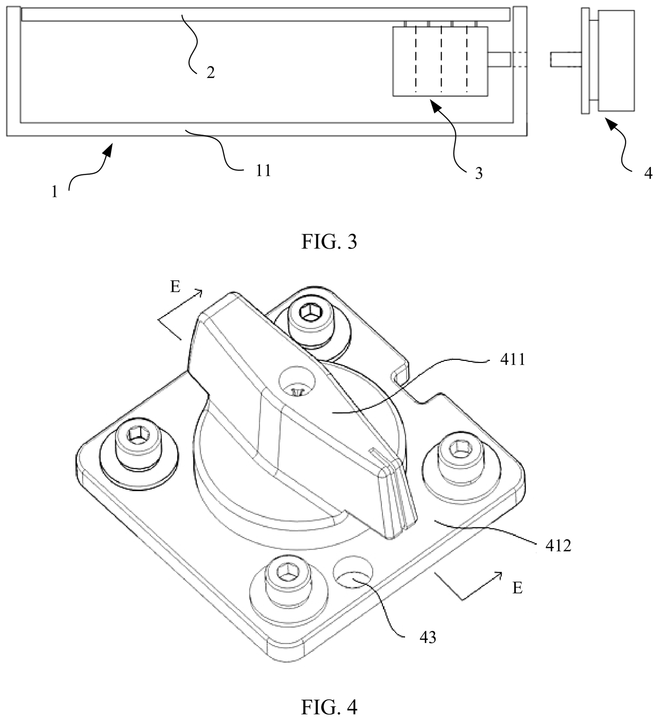

FIG. 2 is a diagram of assembly steps of the inverter shown in FIG. 1. Further, with reference to FIG. 1 and FIG. 2, the housing 1 is configured to accommodate the circuit board 2 and the rotary switch 3. The housing 1 includes two side plates, and the two side plates are oppositely arranged along a first direction A. One side plate a in the two side plates includes a knob mounting hole 101, and the knob mounting hole 101 penetrates the side plate a along the first direction A. The knob component 4 includes a knob 41 and a knob shaft 42. The knob 41 is connected to the knob shaft 42. The knob shaft 42 is configured to pass through the knob mounting hole 101 on the side plate a and be in transmission connection to the operating shaft 32 of the rotary switch 3. The knob 41 is configured to drive, through the knob shaft 42, the operating shaft 32 of the rotary switch 3 to rotate around an axis of the operating shaft 32. The knob 41 and the operating shaft 32 are arranged on two sides of the side plate a along the first direction A. FIG. 3 is a diagram of assembly steps of the inverter shown in FIG. 1. With reference to FIG. 1 to FIG. 3, in this application, the knob shaft 42 in the knob component 4 extends into the housing 1 and is in transmission connection to the operating shaft 32 of the rotary switch 3. When the inverter is assembled, as shown in FIG. 2 and FIG. 3, the circuit board 2 and the rotary switch 3 fastened to the circuit board 2 are placed in the housing 1, and the operating shaft 32 of the rotary switch 3 is enabled to be coaxial with the knob mounting hole 101 on the side plate a of the housing 1. Then, as shown in FIG. 1, the knob shaft 42 is enabled to extend into the housing 1 and be in transmission connection to the operating shaft 32 of the rotary switch 3. In a process of assembling the inverter, the circuit board 2 and the rotary switch 3 fastened to the circuit board 2 do not need to be translated towards the knob mounting hole 101 on the side plate a. Therefore, in an axis direction of the knob mounting hole 101, the housing 1 does not need to have extra installation space other than space for accommodating the circuit board 2 and the rotary switch 3. This can improve space utilization of the housing 1, and help miniaturize the inverter and reduce manufacturing costs.

In addition, compared with a case in which the operating shaft 32 of the rotary switch 3 passes through an operating shaft mounting hole on the housing 1 and is connected to the knob 41, in this solution, for the housing 1 of a same size, the circuit board 2 of a larger size may be disposed; and the rotary switch 3 is fastened in the housing 1 through the circuit board 2, and does not need to be separately connected to the housing 1, so that a problem of redundant fastening of the rotary switch 3 is avoided.

For example, both the axis direction of the operating shaft 32 and an axis direction of the knob shaft 42 overlap the first direction A, in other words, both the operating shaft 32 and the knob shaft 42 are perpendicular to the side plate a. Both the axis direction of the operating shaft 32 and the axis direction of the knob shaft 42 are parallel to the circuit board 2.

Still refer to FIG. 1 and FIG. 2. In a specific implementation, the circuit board 2 includes two end faces. The two end faces of the circuit board 2 are oppositely arranged along the first direction A, and one end face c in the two end faces of the circuit board 2 is closer to the side plate a of the housing 1 than the other end face d. A distance between an end face e of the operating shaft 32 of the rotary switch 3 and the knob mounting hole 101 of the side plate a is greater than or equal to a distance between the end face c of the circuit board 2 and the knob mounting hole 101. In other words, a projection of the operating shaft 32 along a direction perpendicular to the circuit board 2 is at least partially located within a range of the circuit board 2. Clearly, compared with a case in which the operating shaft 32 completely exceeds the circuit board 2 along the first direction A, this solution helps reduce a size of the housing 1 in the first direction A.

In an implementation, the housing 1 includes a bottom plate 11, and the two side plates are both fastened to the bottom plate 11. Further, the circuit board 2 and the bottom plate 11 are oppositely arranged along a second direction B, and the second direction B is perpendicular to the bottom plate 11. Therefore, a size of the inverter in the second direction B can be reduced, and this is more conducive to application in a scenario in which the size of the inverter in the second direction B is limited. For example, the rotary switch 3 is located between the bottom plate 11 and the circuit board 2 along the second direction B.

The housing 1 further includes a cover plate (not shown in the figure) and two connecting plates (not shown in the figure). The two connecting plates are both fastened to the bottom plate 11 and connected between the two side plates. The bottom plate 11, the two connecting plates, and the two side plates jointly enclose an accommodating cavity with an open top, and the cover plate covers an open end of the accommodating cavity. For example, the bottom plate 11, the two side plates, and the two connecting plates of the housing 1 are of an integrally formed structure. Certainly, a connection manner of the bottom plate 11, the two side plates, and the two connecting plates is not limited to integral forming. For example, in another implementation, two adjacent components in the bottom plate 11, the two side plates, and the two connecting plates may be connected through welding or bolting.

When the foregoing side plates are specifically disposed, in an implementation, the two side plates are both flat plates, and the circuit board 2 is perpendicular to the two side plates. This simplifies processing steps of the two side plates, and simplifies an assembly process of the inverter. Similarly, the two connecting plates are also both flat plates. Therefore, processing steps of the two connecting plates can be simplified, and the assembly process of the inverter can also be simplified.

The inverter needs to have good sealing performance. To meet the sealing performance of the inverter, in a specific implementation, the knob 41 in the knob component 4 is in sealing cooperation with the side plate a. Further, a projection of the knob 41 along the first direction A is located in the side plate a. Therefore, a possibility that the knob 41 rotates due to misoperation can be reduced; and compared with a case in which the projection of the knob 41 along the first direction A exceeds a range of the side plate a, a possibility of interference between the knob 41 and a surrounding apparatus or component can be reduced.

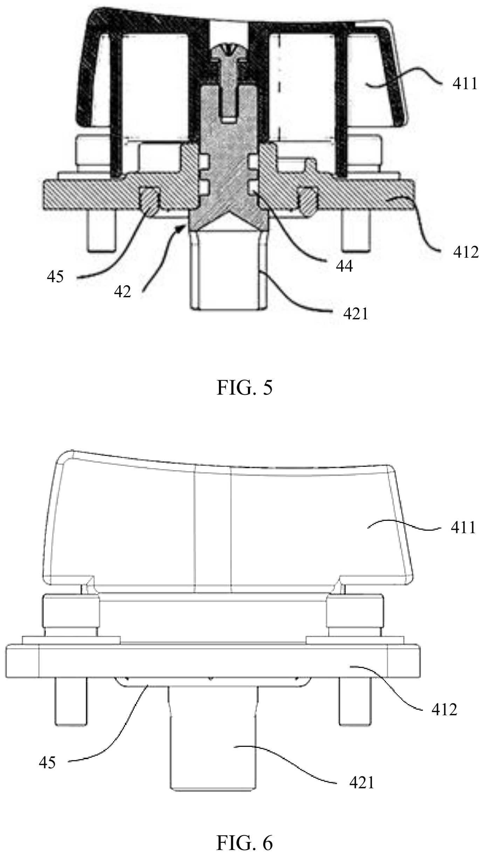

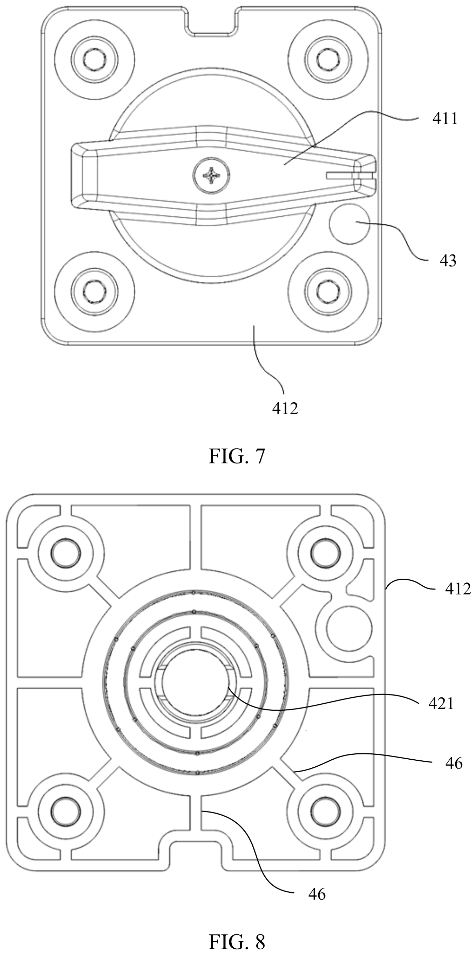

FIG. 4 is an axonometric diagram of a knob component in an inverter according to an embodiment of this application. As shown in FIG. 4, the knob 41 in the knob component 4 includes a handle 411 and a base 412. The base 412 is configured to be fastened to the side plate a of the housing 1. For example, the base 412 includes a plurality of through holes, the side plate a includes threaded holes that are in one-to-one correspondence with the plurality of through holes, and the base 412 is connected to the side plate a using a plurality of screws. FIG. 5 is an E-E sectional view of the knob component shown in FIG. 4, FIG. 6 is a front view of the knob component shown in FIG. 4, and FIG. 7 is a top view of the knob component shown in FIG. 4. Further, as shown in FIG. 5 to FIG. 7, the base 412 includes a knob shaft mounting hole (not shown in the figure) that penetrates the base along the first direction, the knob shaft 42 is inserted into the knob shaft mounting hole, both ends of the knob shaft 42 exceed the knob shaft mounting hole, and the knob shaft 42 can rotate relative to the knob shaft mounting hole. The handle 411 has a knob shaft insertion hole, and one end of the knob shaft 42 is inserted into the knob shaft insertion hole and is fastened in the knob shaft insertion hole. For example, the knob shaft 42 is fastened in the knob shaft insertion hole using a screw. The other end of the knob shaft 42 includes a sleeve 421, and the sleeve 421 is configured to be sleeved on a periphery of the operating shaft 32 of the rotary switch 3 and fastened to the operating shaft 32 of the rotary switch 3, to implement transmission connection between the knob shaft 42 and the operating shaft 32.

Further, the knob component 4 further includes a dynamic sealing ring 44 and a static sealing ring 45. A surface that is of the base 412 and that faces the side plate a of the housing 1 includes a dynamic sealing ring mounting groove (not shown in the figure). The dynamic sealing ring 44 is mounted in the dynamic sealing ring mounting groove, and the dynamic sealing ring 44 exceeds the surface that is of the base 412 and that faces the side plate a of the housing 1. The dynamic sealing ring 44 is configured to implement sealing between the base 412 and the side plate a of the housing 1. A part that is of the knob shaft 42 and that cooperates with the knob shaft mounting hole includes at least one static sealing ring mounting groove. The static sealing ring 45 is mounted in the static sealing ring mounting groove, and the static sealing ring 45 exceeds a surface of the knob shaft 42. The static sealing ring 45 is configured to implement sealing between the knob shaft 42 and the knob shaft mounting hole. A quantity of static sealing ring mounting grooves on the knob shaft 42 may be set based on an actual requirement. For example, the quantity of static sealing ring mounting grooves may be one or two. Clearly, when a plurality of static sealing ring mounting grooves are present, the plurality of static sealing ring mounting grooves are sequentially disposed along the axis direction of the knob shaft 42.

FIG. 8 is a bottom view of the knob component shown in FIG. 4. As shown in FIG. 8, a plurality of reinforcing ribs 46 are disposed on the surface that is of the base 412 and that faces the side plate a of the housing 1, to improve structural strength of the base 412.

In an implementation, the side plate a of the housing 1 includes a housing locking part (not shown in the figure), and the knob 41 includes a knob locking part 43. The housing locking part is configured to cooperate with the knob locking part 43 to limit an orientation of the knob 41 relative to the side plate a, to avoid a case in which the handle 411 of the knob 41 changes an on/off state of the rotary switch due to misoperation. Specifically, the housing locking part is a threaded hole that penetrates the side plate a along the first direction A, and the knob locking part 43 includes a screw (not shown in the figure) and a through hole that penetrates the base 412 along the first direction. The handle 411 includes an initial position and an on/off switching position. When the handle 411 is at the on/off switching position, the on/off state of the rotary switch can be switched. The through hole on the base 412 is located between the initial position and the on/off switching position of the handle 411, an axis of the threaded hole on the side plate a overlaps an axis of the through hole on the base 412, and the screw passes through the through hole on the base 412 and is connected to the threaded hole on the side plate a, to limit an orientation of the handle 411 relative to the side plate a. When the on/off state of the rotary switch needs to be changed, the handle 411 of the knob 41 may be rotated after the screw is removed.

Clearly, a person skilled in the art can make various modifications and variations to this application without departing from the scope of this application. This application is intended to cover these modifications and variations of this application provided that they fall within the scope of protection defined by the claims of this application and their equivalent technologies.

## Claims

1. An inverter, wherein the inverter comprises a housing, a circuit board, a rotary switch, and a knob component, the rotary switch is fastened to the circuit board, the rotary switch comprises a plurality of switches and an operating shaft, and the operating shaft is configured to drive the plurality of switches to be turned on or turned off;
the housing is configured to accommodate the circuit board and the rotary switch, the housing comprises two side plates, the two side plates are oppositely arranged along a first direction, one side plate in the two side plates comprises a knob mounting hole, and the knob mounting hole penetrates the side plate along the first direction; and
the knob component comprises a knob and a knob shaft, the knob shaft is configured to pass through the knob mounting hole and be in transmission connection to the operating shaft, the knob is configured to drive, through the knob shaft, the operating shaft to rotate, and the knob and the operating shaft are arranged on two sides of the side plate along the first direction.

2. The inverter according to claim 1, wherein the circuit board comprises two end faces, the two end faces are oppositely arranged along the first direction, and one end face in the two end faces is closer to the side plate than the other end face; and
a distance between an end face of the operating shaft and the knob mounting hole is greater than or equal to a distance between the end face and the knob mounting hole.

3. The inverter according to claim 1, wherein the housing comprises a bottom plate, the two side plates are both fastened to the bottom plate, the circuit board and the bottom plate are oppositely arranged along a second direction, and the second direction is perpendicular to the bottom plate.

4. The inverter according to claim 1, wherein the two side plates are both flat plates, and the circuit board is perpendicular to the two side plates.

5. The inverter according to claim 3, wherein the rotary switch is located between the bottom plate and the circuit board along the second direction.

6. The inverter according to any one of claims 1 to 5, wherein the knob is in sealing cooperation with the side plate, and a projection of the knob along the first direction is located in the side plate.

7. The inverter according to any one of claims 1 to 5, wherein both an axis direction of the operating shaft and an axis direction of the knob shaft overlap the first direction.

8. The inverter according to any one of claims 1 to 5, wherein both an axis direction of the operating shaft and an axis direction of the knob shaft are parallel to the circuit board.

9. The inverter according to any one of claims 1 to 5, wherein the plurality of switches are sequentially arranged along an axis direction of the operating shaft.

10. The inverter according to any one of claims 1 to 5, wherein the side plate comprises a housing locking part, the knob comprises a knob locking part, and the housing locking part can cooperate with the knob locking part to limit an orientation of the knob relative to the side plate.
